# EUROPÄISCHE PATENTSCHRIFT

(11) **EP 1 504 301 B1**
(45) Veröffentlichungstag und Bekanntmachung des Hinweises auf die Patenterteilung: **12.12.2007**
(21) Anmeldenummer: 03725166.7
(22) Anmeldetag: 07.05.2003
(51) Int. Cl.: G02F 1/133, G02F 1/1333, H01L 31/0392

(54) **VORRICHTUNG MIT SOLARZELLENANORDNUNG UND FLÜSSIGKRISTALLANZEIGE**
DEVICE COMPRISING A SOLAR CELL ARRANGEMENT AND A LIQUID CRYSTAL DISPLAY
DISPOSITIF COMPRENANT UN DISPOSITIF CELLULE SOLAIRE ET UN AFFICHEUR A CRISTAUX LIQUIDES

(30) Priorität: 14.05.2002 DE 10221301
(43) Veröffentlichungstag der Anmeldung: 09.02.2005
(73) Patentinhaber: JUNGHANS UHREN GMBH, 78713 Schramberg (DE)
(72) Erfinder: BRUMMACK, Hanna, 79215 Elzach (DE); MEGNER, Günter, 88690 Uhldingen (DE)
(74) Vertreter: Neunert, Peter Andreas
(86) Internationale Anmeldenummer: PCT/EP2003/004786
(87) Internationale Veröffentlichungsnummer: WO 2003/096109

(56) Entgegenhaltungen:
- US-A1- 2002 027 620
- PATENT ABSTRACTS OF JAPAN Bd. 1999, Nr. 04, 30. April 1999 (1999-04-30) -& JP 11 015396 A (CITIZEN WATCH CO LTD), 22. Januar 1999 (1999-01-22)
- PATENT ABSTRACTS OF JAPAN Bd. 2000, Nr. 01, 31. Januar 2000 (2000-01-31) -& JP 11 296636 A (TOPPAN PRINTING CO LTD), 29. Oktober 1999 (1999-10-29)
- PATENT ABSTRACTS OF JAPAN Bd. 2000, Nr. 24, 11. Mai 2001 (2001-05-11) -& JP 2001 183616 A (MINOLTA CO LTD), 6. Juli 2001 (2001-07-06)

## Beschreibung

Die Erfindung betrifft eine Vorrichtung mit Solarzellenanordnung und Flüssigkristallanzeige gemäß dem Oberbegriff des Anspruchs 1.

Eine solche Vorrichtung ist aus Patent Abstracts of Japan Bol. 1999, Nv. 04 30. April 1999-& JP 11 015396 A bekannt.

Solarzellenanordnungen, nämlich einzelne Solarzellen sowie Anordnungen, sog. Module aus mehreren oder einer Vielzahl miteinander verschalteter Einzelzellen sind gemäß dem Stand der Technik in einer Vielzahl von Abwandlungen bekannt. Ebenso sind Flüssigkristallanzeigen, sogenannte LCDs (LCD = Liquid crystal displays) in vielerlei Ausführungsvarianten bekannt. Solarzellenanordnungen und Flüssigkristallanzeigen sind als separate Bauteile für unterschiedlichste Einsatzzwecke kommerziell erhältlich.

Es ist auch seit langem bekannt, eine Solarzellenanordnung als Energiequelle einer Uhr, insbesondere einer Armbanduhr, einzusetzen. Ferner ist es bekannt Flüssigkristallanzeigen zum Anzeigen der Uhrzeit, des Datums oder dergleichen zu verwenden.

Derzeit ist die überwiegende Anzahl von Armbanduhren mit einem analog anzeigenden Zeigerwerk ausgestattet. Aus diesem Grund ist die als Energiequelle dienende Solarzellenanordnung einer Armbanduhr der vorgenannten Art üblicherweise in der Art eines Zifferblatts ausgestaltet. Bei vielen dieser als Solararmbanduhren bekannten solarbetriebenen Armbanduhren ist eine vorerwähnte Flüssigkristallanzeige zur Anzeige des Datums oder sonstiger Sonderfunktionen in dieses Zifferblatt eingesetzt.

Bei derartigen Solararmbanduhren sind die Solarzifferblätter und die Flüssigkristallanzeigen getrennte Bauteile, die üblicherweise übereinanderliegend angeordnet sind.

Nachteilig bei einer derartigen Hintereinanderanordnung ist der "Tunneleindruck" beim Ablesen einer hinter einem sogenannten Datumsfenster angeordneten Flüssigkristallanzeige.

Der Erfindung liegt die Aufgabe zugrunde, eine Vorrichtung mit Solarzellenanordnung und Flüssigkristallanzeige vorzustellen, welche neue Anzeigemöglichkeiten und Effekte zur Überlagerung der beiden optischen Elemente, nämlich der Solarzellenanordnung und der Flüssigkristallanzeige, ermöglicht.

Diese Aufgabe wird durch eine Vorrichtung mit Solarzellenanordnung und Flüssigkristallanzeige mit den Merkmalen des Anspruchs 1 oder des Anspruchs 2 gelöst.

Vorteilhafte Ausführungen und Weiterbildungen der Erfindung sind in den Unteransprüchen gegeben.

Die Erfindung geht ganz allgemein von Solarzellenanordnungen und Flüssigkristallanzeigen an sich bekannter Art aus. So weisen Solarzellenanordnungen in gestapelter Anordnung wenigstens einen zumindestens teilweise transparenten Träger für eine oder mehrere Solarzellen auf, welche ggf. auch zu einem oder mehreren Modulen verschaltet sein können. Jede Solarzelle umfaßt wiederum wenigstens eine photovoltaisch aktive Schicht, welche zwischen einem zumindestens teilweise transparenten Kontakt und einem in der Regel metallischen Kontakt eingebettet ist.

Dem Fachmann auf den einschlägigen Gebiet ist bekannt, dass die vorgenannt Solarzellenstruktur auch die übereinander angeordneten mehrere solcher Stapelfolgen umfassen kann, insbesondere sind auch sog. Mehrfachjunctionanordnungen eingeschlossen.

Als Trägermaterial von sogenannten Dünnschichtsolarzellenanordnungen, beispielsweise von solchen, bei denen die photovoltaisch aktive Schicht amorphes Silizium ist, wird üblicherweise Glas verwendet. Es kommen jedoch auch Kunststoffe, Keramiken oder dergleichen als Trägermaterialien in Betracht.

Bei Solarzellenanordnungen mit kristallinen Materialien als photovoltaisch aktiver Schicht, wie beispielsweise kristallines Silizium, kann dieses kristalline Material selbst die Funktion des Trägers übernehmen.

Die Flüssigkristallanzeige, derer sich die Erfindung bedient, weist in gestapelter Anordnung wenigstens einen ersten Polarisator, einen ersten zumindestens teilweise transparenten Träger, einen ersten zumindestens teilweise transparenten Kontakt, einen Flüssigkristall, einen zweiten transparenten Kontakt, einen zweiten transparenten Träger, einen zweiten Polarisator und einen Reflektor auf.

Der wesentliche Gedanke der Erfindung besteht nun darin, die beiden bislang als Einzelbauteile vorliegenden Elemente der Vorrichtung, Solarzellenanordnung und Flüssigkristallanzeige zu einem einzigen Bauteil zu verbinden und zwar vorzugsweise in der Weise, dass die optischen Ebenen der photovoltaisch aktiven Schicht und der Flüssigkristallanzeige im Wesentlichen zusammenfallen. Dies wird erfindungsgemäß dadurch realisiert, dass ein Träger der Flüssigkristallanzeige als Träger der Solarzellenanordnung dient.

Prinzipiell kann die Flüssigkristallanzeige unter- oder oberhalb der Solarzellenanordnung oder auch innerhalb einer Aussparung der Solarzellenanordnung angebracht sein. Die Solarzellenanordnung oder Teile derselben können hierbei auch Funktionen von Teilen der Flüssigkristallanzeige übernehmen (oder umgekehrt), so dass die Gesamtbauhöhe deutlich reduziert wird.

In einer ersten Variante der Erfindung ist vorgesehen, dass der Träger der Solarzellenanordnung der erste Träger der Flüssigkristallanzeige ist. In diesem Fall liegt die Flüssigkristallanzeige unterhalb der Solarzellenanordnung. Im einfachsten Fall des nicht teil des Erfindung ist, sind die Solarzellenanordnung und die Flüssigkristallanzeige benachbart aber lateral getrennt voneinander angeordnet. In diesem Fall ist die Solarzellenanordnung und die Flüssigkristallanzeige weiter nahezu vollständig entkoppelt. Es ist jedoch auch möglich, dass sich die Solarzellenanordnung und die Flüssigkristallanzeige zumindest partiell lateral überlappen.

Bei der erstgenannten Ausführungsvariante bietet es sich vorteilhafterweise an, den transparenten Kontakt der Solarzellenanordnung auch als ersten transparenten Kontakt der Flüssigkristallanzeige bzw. umgekehrt den ersten transparenten Kontakt der Flüssigkristallanzeige auch als ersten transparenten Kontakt der Solarzellenanordnung zu verwenden, um einerseits Bauhöhe einzusparen und andererseits die Zahl der Prozessschritte zur Herstellung einer derartigen Vorrichtung mit Solarzellenanordnung und Flüssigkristallanzeige so gering wie möglich zu halten.

Für die Zweitvariante, die zumindestens teilweise lateral überlappende Anordnung von Solarzellenanordnung und Flüssigkristallanzeige, ist es vorteilhaft, die Solarzellenanordnung zumindestens teilweise semitransparent auszubilden. Vorzugsweise ist die Solarzellenanordnung gerade in diesem überlappenden Bereich semitransparent ausgebildet. Eine derartige Überlagerung der beiden optischen Elemente bietet neue Anzeigemöglichkeiten und Effekte.

Zwei Ausführungsbeispiele der Erfindung sind in den Zeichnungen dargestellt. Diese werden im folgenden näher beschrieben. Es zeigen:
- Figur 1: eine erste Ausführungsvariante eines Solarzifferblatts einer Uhr mit erfindungsgemäß angeordneter Flüssigkristallanzeige im Querschnitt.
- Figur 2: einen prinzipiellen Aufbau einer Solarzelle gemäß dem Stand der Technik.
- Figur 3: einen prinzipiellen Aufbau der Flüssigkristallanzeige gemäß dem Stand der Technik.
- Figur 4: eine zweite Ausführungsvariante eines Solarzifferblatts einer Uhr mit erfindungsgemäß angeordnete Flüssigkristallanzeige im Querschnitt.
- Figur 5: einen prinzipiellen Aufbau einer Solarzelle gemäß dem Stand der Technik.

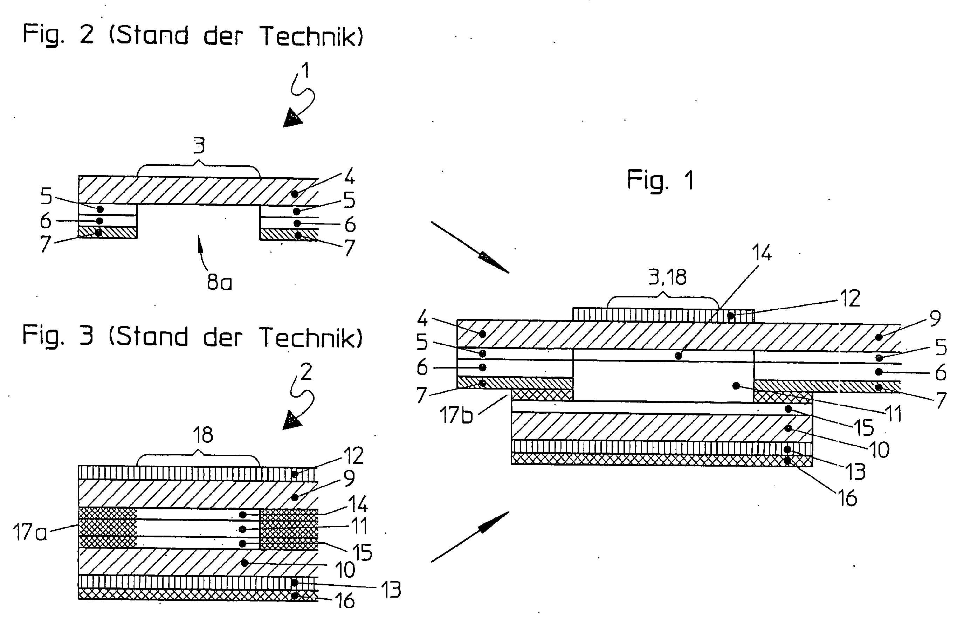

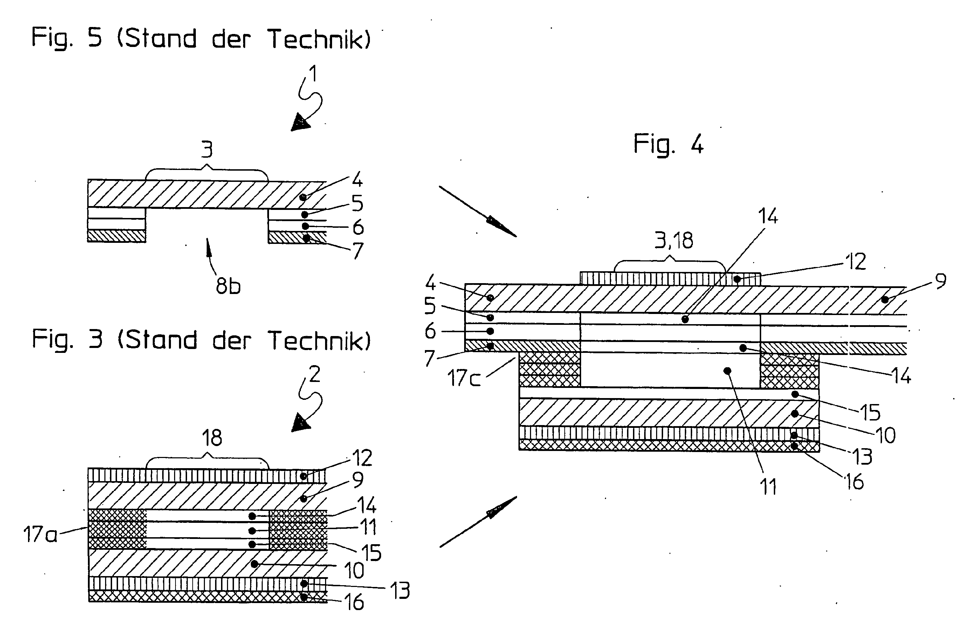

Die in der Zeichnungsfigur 1 skizzierte erste Ausführungsvariante eines Solarzifferblatts einer Uhr, insbesondere einer Armbanduhr, bedient sich einer Solarzellenanordnung 1 sowie einer Flüssigkristallanzeige 2 an sich bekannter Art. Die Figuren 2 und 3 zeigen den prinzipiellen Aufbau eines Solarzifferblatts gemäß dem Stand der Technik sowie einer Flüssigkristallanzeige 2 gemäß dem Stand der Technik, wie sie zur Zeit zum Einsatz kommen.

Das Solarzifferblatt entspricht in seiner Struktur im vorliegenden Ausführungsbeispiel einer einfachen Solarzelle 1. Es versteht sich für den Fachmann von selbst, dass das Solarzifferblatt auch aus einer Mehrzahl derartiger Einzelzellen aufgebaut sein kann, welche in entsprechender Weise miteinander (ggf. auch unmittelbar auf dem Substrat) verschaltet sein können.

Das Solarzifferblatt besteht im vorliegenden Fall aus einem transparenten Träger 4 aus Glas, worauf der transparente (Front-) Kontakt 5 aus transparentem leitfähigen Metalloxid (TCO = transparent conductive oxide), die photovoltaisch aktive Schicht 6 aus amorphem Silizium und der (Rück-) Kontakt 7 aus Metall aufgebracht sind. Im Bereich des (Datums-) Fensters 3 sind diese drei Schichten, transparenter Kontakt 5, photovoltaisch aktive Schicht 6 und Kontakt 7 eine Öffnung 8a bildend entfernt.

Die Flüssigkristallanzeige 2 (LCD = liquid crystals display) besteht aus dem aktiven Flüssigkristall 11, welcher durch zwei miteinander verklebte, mit TCO beschichtete transparente Träger 9, 10 kontaktiert wird, zwei Polarisatoren 12, 13 und einem Reflektor 16. Die beiden transparenten Kontakte darstellenden TCO-Beschichtungen sind in der Zeichnungsfigur durch die Bezugszeichen 14 und 15 gekennzeichnet, die Verklebung durch das Bezugszeichen 17a. Es sei darauf hingewiesen, dass die üblicherweise eine Strukturierung (entsprechend den anzuzeigenden Ziffern) aufweisenden TCO-Schichten der Einfachheit halber ganzflächig skizziert sind.

Die Darstellung gemäß der Figur 1 zeigt die Kombination der beiden vorbeschriebenen Elemente, die das Solarzifferblatt darstellende Solarzelle 1 und die Flüssigkristallanzeige 2, in der Weise, dass der transparente Träger 4, das Substratglas, der Solarzelle 1 gleichzeitig die Funktion des ersten transparenten Trägers 9, in der Fachsprache auch als LCD-Deckglas bezeichnet, übernimmt. In dieser Struktur fallen die optischen Ebenen der photovoltaisch aktiven Schicht 6 und der Flüssigkristallanzeige 2 zusammen. Dies bedeutet konkret, dass die Ziffern der Flüssigkristallanzeige 2 in derselben Ebene wie das (Datums-) Fenster 3 erscheinen.

Die vorstehend beschriebene Ausführungsvariante eines Solarziffernblatts (Solarzelle 1) einer Uhr mit Flüssigkristallanzeige 2 läßt sich wie folgt herstellen:

Zunächst muss die Solarzelle 1 fertiggestellt werden, da die hierzu nötigen Prozesstemperaturen den Flüssigkristall 11 und damit die Flüssigkristallanzeige 2 schädigen können. Anschließend wird das (Datums-) Fenster 3 freigelegt. Werden in diesem Bereich nur das Metall des Kontakts 7 und die photovoltaisch aktive Schicht 6 entfernt, kann der transparente Kontakt 5, die TCO-Schicht, der Solarzelle 1 entsprechend strukturiert und zur Kontaktierung des Flüssigkristalls 11 genutzt werden. Es ist jedoch auch möglich, zumindest in diesem Bereich eine zusätzliche TCO-Schicht als transparenten Kontakt 14 aufzubringen. Die Verklebung 17b mit dem zweiten transparenten Träger 10 erfolgt außerhalb des sichtbaren Bereichs, der durch die Öffnung 8 in der photovoltaisch aktiven Schicht 6 vorgegeben ist. Schließlich wird der erste Polarisator 12 oben auf der das Solarzifferblatt darstellenden Solarzelle 1 aufgebracht.

In ähnlicher Weise ergibt sich die in der Figur 4 gezeigte zweite Ausführungsvariante eines Solarzifferblatts eine Uhr mit erfindungsgemäß angeordneter Flüssigkristallanzeige 3.

Ausgangselemente sind ähnlich wie im vorgenannten Ausführungsbeispiel eine Dünnschichtsolarzelle 1 und eine Flüssigkristallanzeige 2 gemäß dem Stand der Technik, wie sie den Figuren 5 und 3 zu entnehmen sind. Die in der Figur 4 dargestellte Variante unterscheidet sich von der vorgehend beschriebenen Ausführungsvariante lediglich darin, dass bei der das Solarzifferblatt bildenden Solarzelle 1 im Bereich des (Datums-) Fensters 3 nicht alle drei auf den Träger 4 aufgebrachten Schichten, nämlich transparenter Kontakt 5, photovoltaisch aktiven Schicht 6 und (Metall-) Kontakt 7 entfernt wurden, sondern lediglich der üblicherweise nicht transparente (Metall-) Kontakt 7. Wird nunmehr die photovoltaisch aktive Schicht 6 semitransparent ausgeführt, ergeben sich auf diese Weise neue Anzeigemöglichkeiten und Effekte durch Überlagerung der beiden optischen Elemente, Solarzelle 1 und Flüssigkristallanzeige 2.

### Bezugszeichenliste

- 1: Solarzelle
- 2: Flüssigkristallanzeige
- 3: Fenster
- 4: transparenter Träger
- 5: transparenter Kontakt
- 6: photovoltaisch aktive Schicht
- 7: Kontakt
- 8: Öffnung
- 9: erster transparenter Träger
- 10: zweiter transparenter Träger
- 11: Flüssigkkritall
- 12: erster Polarisator
- 13: zweiter Polarisator
- 14: erster transparenter Kontakt
- 15: zweiter transparenter Kontakt
- 16: Reflektor
- 17a, 17b: Verklebung
- 18: Anzeigefläche

## Patentansprüche

1. Vorrichtung mit Solarzelle (1) und Flüssigkristallanzeige (2), wobei die Solarzelle (1) in gestapelter Anordnung aufweist:
- einen transparenten Träger (4),
- einen transparenten Kontakt (5),
- eine photovoltaisch aktive Schicht (6), und
- einen Kontakt (7),
- eine Aussparung (3), gebildet durch Entfernen der photovoltaisch aktiven Schicht (6) und des Kontakts (7),
**gekennzeichnet durch** folgende weitere Merkmale zur Bildung der Flüssigkristallanzeige (2):
- auf dem transparenten Träger (4) sitzt auf seiner der Aussparung (3) gegenüber liegenden Seite im Bereich oberhalb der Aussparung (3) ein erster Polarisator (12),
- in der Aussparung (3) ist ein aktiver Flüssigkristall (11) angeordnet
- auf der dem transparenten Träger (4) abgewandten Seite des Flüssigkristalls (11) sitzt in gestapelter Anordnung vom Flüssigkeitskristall aus gesehen:
- ein weiterer transparenter Kontakt (15),
- ein weiterer transparenter Träger (10),
- ein weiterer Polarisator (13),
- ein Reflektor (16),
wobei die gestapelte Anordnung die Aussparung (3) überdeckt und im außerhalb der Aussparung (3) überdeckenden Bereich der weitere transparente Kontakt (15) mit dem Kontakt (7) **durch** Verklebung (17b) verbunden ist, so dass der Flüssigkeitskristall (11) in der Aussparung (3) und zwischen beiden transparenten Kontakten (14, 15) eingeschlossen ist.

2. Vorrichtung mit Solarzelle (1) und Flüssigkristallanzeige (2), wobei die Solarzelle (1) in gestapelter Anordnung aufweist:
- einen transparenten Träger (4),
- einen transparenten Kontakt (5),
- eine photovoltaisch aktive Schicht (6), und
- einen Kontakt (7),
- eine Aussparung (3), gebildet durch Entfernen des Kontakts (7)
**gekennzeichnet durch** folgende weitere Merkmale zur Bildung der Flüssigkristallanzeige (2):
- auf dem transparenten Träger (4) sitzt auf seiner der Aussparung (3) gegenüberliegenden Seite im Bereich oberhalb der Aussparung (3) ein erster Polarisator (12),
- in der Aussparung (3) ist ein transparenter Kontakt (14) angeordnet,
- darunter schließt sich ein aktiver Flüssigkeitskristall (11) an,
- auf der dem transparenten Kontakt (14) abgewandten Seite des Flüssigkristalls (11) sitzt in gestapelter Anordnung vom Flüssigkeitskristall (11) aus gesehen:
- ein weiterer transparenter Kontakt (15),
- ein weiterer transparenter Träger (10),
- ein weiterer Polarisator (13),
- ein Reflektor (16),
wobei die gestapelte Anordnung die Aussparung (3) überdeckt und im außerhalb der Aussparung (3) überdeckenden Bereich der weitere transparente Kontakt (15) mit dem Kontakt (7) **durch** Verklebung 17b) verbunden ist,
wobei der Flüssigkeitskristall (11) zwischen den transparenten Kontakten (14, 15) und der Verklebung (17c) eingeschlossen ist.

3. Vorrichtung nach Anspruch 2,
**dadurch gekennzeicnet, dass** die photovoltaisch aktive Schicht (6) semitransparent ausgebildet ist.

4. Vorrichtung nach einem der Ansprüche 1 bis 3,
**dadurch gekennzeichnet, dass** diese Bestandteil einer Uhr, insbesondere Armbanduhr, ist.

5. Vorrichtung nach Anspruch 4,
**dadurch gekennzeichnet, dass** der obere, transparente Träger (4) das Substratglas der Solarzelle (1) und auch das LCD-Deckglas der Uhr bildet.

6. Vorrichtung nach Anspruch 4 oder 5,
**dadurch gekennzeichnet, dass** die Aussparung (3) ein Fenster und insbesondere ein Datumsfenster der Uhr ist.

## Claims

1. Device with solar cell (1) and liquid crystal display (2), wherein the solar cell (1) has, in a stacked arrangement:
- a transparent carrier (4),
- a transparent contact (5),
- a photovoltaically active layer (6), and
- a contact (7),
- a recess (3), formed by the removal of the photovoltaically active layer (6) and of the contact (7),
**characterised by** the following additional features to form the liquid crystal display (2):
- seated on the transparent carrier (4), on its side opposite the recess (3), in the area above the recess (3), is a first polarizer (12),
- arranged in the recess (3) is an active liquid crystal (11),
- located on that side of the liquid crystal (11) facing away from the transparent carrier (4), in a stacked arrangement, viewed from the liquid crystal (11), are:
- an additional transparent contact (15),
- an additional transparent carrier (10),
- an additional polarizer (13),
- a reflector (16),
wherein the stacked arrangement covers over the recess (3) and, in that area outside the area covering the recess (3), the additional transparent contact (15) is connected to the contact (7) by means of adhesive attachment (17b), so that the liquid crystal (11) is enclosed in the recess (3) and between the two transparent contacts (14, 15).

2. Device with solar cell (1) and liquid crystal display (2), wherein the solar cell (1) has, in a stacked arrangement:
- a transparent carrier (4),
- a transparent contact (5),
- a photovoltaically active layer (6), and
- a contact (7),
- a recess (3), formed by the removal of the contact (7),
**characterised by** the following additional features to form the liquid crystal display (2):
- seated on the transparent carrier (4), on its side opposite the recess (3), in the area above the recess (3), is a first polarizer (12),
- arranged in the recess (3) is a transparent contact (14),
- following on underneath this is an active liquid crystal (11),
- located on that side of the liquid crystal (11) facing away from the transparent contact (14), in a stacked arrangement, viewed from the liquid crystal (11), are:
- an additional transparent contact (15),
- an additional transparent carrier (10),
- an additional polarizer (13),
- a reflector (16),
wherein the stacked arrangement covers over the recess (3) and, in that area outside the area covering the recess (3), the additional transparent contact (15) is connected to the contact (7) by means of adhesive attachment (17b),
wherein the liquid crystal (11) is enclosed between the transparent contacts (14, 15) and the adhesive attachment (17c).

3. Device according to claim 2, **characterised in that** the photovoltaically active layer (6) is designed to be semi-transparent.

4. Device according to one of the claims 1 to 3, **characterised in that** it is a component of a clock or watch, in particular a wristwatch.

5. Device according to claim 4, **characterised in that** the upper transparent carrier (4) forms the substrate glass of the solar cell (1) and also the LCD cover glass of the clock or watch.

6. Device according to claim 4 or 5, **characterised in that** the recess (3) is a window and in particular a date window of the clock or watch.

## Revendications

1. Dispositif comprenant une cellule solaire (1) et un affichage à cristaux liquides (2), la cellule solaire (1), dans une disposition empilée, présentant :
- un support transparent (4),
- un contact transparent (5),
- une couche active photovoltaïque (6), et
- un contact (7),
- un évidement (3), formé par l'enlèvement de la couche active photovoltaïque (6) et du contact (7),
**caractérisé par**
les autres caractéristiques suivantes pour la formation de l'affichage à cristaux liquides (2) :
- sur le support transparent (4) se trouve, sur son côté opposé à l'évidement (3), dans la zone au-dessus de l'évidement (3), un premier polarisateur (12),
- dans l'évidement (3) est disposé un cristal liquide actif (11),
- sur le côté du cristal liquide (11) opposé au support transparent (4) se trouvent, dans une disposition empilée, vus à partir du cristal liquide :
- un autre contact transparent (15),
- un autre support transparent (10),
- un autre polarisateur (13),
- un réflecteur (16),
la disposition empilée recouvrant l'évidement (3) et dans la zone de recouvrement à l'extérieur de l'évidement (3), l'autre contact transparent (15) étant relié au contact (7) par collage (17b), de telle sorte que le cristal liquide (11) est incorporé dans l'évidement (3) entre deux contacts transparents (14, 15).

2. Dispositif comprenant une cellule solaire (1) et un affichage à cristaux liquides (2), la cellule solaire (1), dans une disposition empilée, présentant :
- un support transparent (4),
- un contact transparent (5),
- une couche active photovoltaïque (6), et
- un contact (7),
- un évidement (3), formé par l'enlèvement du contact (7),
**caractérisé par**
les autres caractéristiques suivantes pour la formation de l'affichage à cristaux liquides (2):
sur le support transparent (4) se trouve, sur son côté opposé à l'évidement (3), dans la zone au-dessus de l'évidement (3), un premier polarisateur (12),
- dans l'évidement (3) est disposé un contact transparent (14),
- en dessous s'y rattache un cristal liquide actif (11),
- sur le côté du cristal liquide (11) opposé au contact transparent (14) se trouvent, dans une disposition empilée, vus à partir du cristal liquide (11) :
- un autre contact transparent (15),
- un autre support transparent (10),
- un autre polarisateur (13),
- un réflecteur (16),
la disposition empilée recouvrant l'évidement (3) et dans la zone de recouvrement à l'extérieur de l'évidement (3), l'autre contact transparent (15) étant relié au contact (7) par collage (17b),
le cristal liquide (11) étant incorporé entre les contacts transparents (14, 15) et le collage (17c).

3. Dispositif selon la revendication 2,
**caractérisé en ce que**
la couche active photovoltaïque (6) est semi-transparente.

4. Dispositif selon l'une des revendications 1 à 3,
**caractérisé en ce que**
ce composant est une montre, en particulier une montre-bracelet.

5. Dispositif selon la revendication 4,
**caractérisé en ce que**
le support transparent supérieur (4) forme le substrat en verre de la cellule solaire (1) et également le verre de couverture LCD de la montre.

6. Dispositif selon la revendication 4 ou 5,
**caractérisé en ce que**
l'évidement (3) est une fenêtre et en particulier une fenêtre de date de la montre.
